# EUROPEAN PATENT APPLICATION

(11) **EP 4 485 172 A1**
(43) Date of publication of application: **01.01.2025**
(21) Application number: 23759027.8
(22) Date of filing: 09.02.2023
(51) Int. Cl.: G06F 8/35

(54) **DATA MODELING METHOD AND APPARATUS, AND DEVICE AND STORAGE MEDIUM**

(30) Priority: 25.02.2022 CN 202210179833
(71) Applicant: Alibaba Innovation Private Limited, Singapore 189554 (SG)
(72) Inventor: ZHAO, Liang, Hangzhou, Zhejiang 310030 (CN); HUANG, Kuoling, Bellevue, WA 98004 (US); YIN, Wotao, Hangzhou, Zhejiang 311121 (CN)
(74) Representative: Finnegan Europe LLP
(86) International application number: PCT/CN2023/075175
(87) International publication number: WO 2023/160402

(57) **Abstract**

The present invention provides a data modeling method, apparatus and device, and a storage medium. The method includes: acquiring a model file and a data file, the model file including code for modeling a to-be-solved problem corresponding to a target application system, the code including a plurality of parameters, and the data file at least including parameter values corresponding to part of the parameters; in response to a running operation triggered by a user for a target segment of code in the model file, in a case of determining that the target segment of code includes unassigned parameters, displaying prompt information corresponding to the unassigned parameters for prompting input of corresponding parameter values; and according to the parameter values corresponding to the unassigned parameters inputted by the user and parameter values corresponding to assigned parameters in the target segment of code, generating a model instance corresponding to the target segment of code. Based on the novel model file running mode provided in the embodiment of the present invention, model debugging is more flexible, so that a better model can be formed.

## Description

This application claims the priority of the Chinese patent application with the application number 202210179833.3 and the title of "DATA MODELING METHOD, APPARATUS AND DEVICE, AND STORAGE MEDIUM" filed with China National Intellectual Property Administration on February 25, 2022, the entire contents of which are incorporated herein by reference.

### TECHNICAL FIELD

The present invention relates to the technical field of data processing, and specifically relates to a data modeling method, apparatus and device, and a storage medium.

### BACKGROUND

In many application scenarios, there are optimization problems that need to be solved, so mathematical modeling and solving of optimization problems has become a widely adopted solution idea. In a current process of using modeling tool software, users often need to prepare complete model files and data files, then call a certain modeling language to parse the model files, and load the corresponding data files to complete the modeling of a model instance, and finally use the solver to solve the model instance obtained by modeling. This mode has many inconveniences and is less flexible in the stage of model development and debugging.

### SUMMARY

An embodiment of the present invention provides a data modeling method, apparatus and device, and a storage medium, aiming to improve the modeling flexibility.

In a first aspect, an embodiment of the present invention provides a data modeling method, including:
acquiring a model file and a data file, the model file including code for modeling a to-be-solved problem corresponding to a target application system, the code including a plurality of parameters, and the data file at least including parameter values corresponding to part of the parameters;
in response to a running operation triggered by a user for a target segment of code in the model file, in a case of determining that the target segment of code includes unassigned parameters, displaying prompt information corresponding to the unassigned parameters for prompting input of corresponding parameter values; and
according to the parameter values corresponding to the unassigned parameters inputted by the user and parameter values corresponding to assigned parameters in the target segment of code, generating a model instance corresponding to the target segment of code.

In a second aspect, an embodiment of the present invention provides a data modeling apparatus, including:
an acquisition module which is configured to acquire a model file and a data file, the model file including code for modeling a to-be-solved problem corresponding to a target application system, the code including a plurality of parameters, and the data file at least including parameter values corresponding to part of the parameters;
a determination module which is configured to, in response to a running operation triggered by a user for a target segment of code in the model file, determine whether the target segment of code include unassigned parameters;
a display module which is configured to, in a case of determining that the target segment of code includes unassigned parameters by the determination module, display prompt information corresponding to the unassigned parameters for prompting input of corresponding parameter values; and
a generation module which is configured to, according to the parameter values corresponding to the unassigned parameters inputted by the user and parameter values corresponding to assigned parameters in the target segment of code, generate a model instance corresponding to the target segment of code.

In a third aspect, an embodiment of the present invention provides an electronic device, including: a memory, a processor, and a communication interface; executable code is stored on the memory; where when the executable code is executed by the processor, the processor executes at least the data modeling method in the first aspect.

In a fourth aspect, an embodiment of the present invention provides a non-temporary machine-readable storage medium which can store executable code; where when the executable code is executed by a processor of an electronic device, the processor executes at least the data modeling method in the first aspect.

In a fifth aspect, an embodiment of the present invention provides a data modeling method of an electric power system, including:
acquiring a model file and a data file, the model file including code for modeling a node electricity price solving problem corresponding to the electric power system, the code including a plurality of parameters, the data file at least including parameter values corresponding to part of the parameters, and the plurality of parameters including parameters for representing power grid state information;
in response to a running operation triggered by a user for a target segment of code in the model file, in a case of determining that the target segment of code includes unassigned parameters, displaying prompt information corresponding to the unassigned parameters for prompting input of corresponding parameter values;
according to the parameter values corresponding to the unassigned parameters inputted by the user and parameter values corresponding to assigned parameters in the target segment of code, generating a model instance corresponding to the target segment of code; and
calling a solver corresponding to the model instance to solve variables of the model instance.

In summary, the model file includes the code for modeling the to-be-solved problem corresponding to the target application system, and the code are mainly used for defining various functions, equations, inequations, variables and parameters corresponding to the to-be-solved problem. The data file includes related data required to be used in the model instance modeling process, and mainly includes parameter values of various parameters.

According to the embodiment of the present invention, when a developer develops the model file, the developer is not required to set parameter values of all parameters in the model file, for example, corresponding parameter values or corresponding reading paths of the parameter values in a data file are directly given in the model file, but the developer is not required to perform assignment operation on the parameter values of some parameters. In addition, different from traditional modeling tool software which only allows to execute a complete model file in one modeling process, this embodiment of the present invention allows the user (which can be the developer or a debugger) to select part of code in the model file to run. Based on this, when the user triggers the running operation for the target segment of code in the model file, whether the target segment of code includes unassigned parameters or not is firstly determined, and if it is found that the target segment of code includes unassigned parameters after traversing is completed, the prompt information corresponding to the unassigned parameters is displayed for prompting the input of the corresponding parameter values. After the parameter values corresponding to the unassigned parameters inputted by the user based on the prompt information is received, the target segment of code is run again, so that the model instance corresponding to the target segment of code is generated according to the parameter values corresponding to the unassigned parameters inputted by the user and parameter values corresponding to assigned parameters in the target segment of code.

In the modeling solution according to the embodiment of the present invention, the configuration modeling tool software may support the setting of unassigned parameters and a certain specific running mode. In this running mode, firstly, the unassigned parameters in the running code segment are traversed and determined, then prompt information is outputted to enable the user to input currently needed parameter values according to needs, and then the code segment runs to complete corresponding model instance modeling. This running mode is convenient for the user to debug the model file according to needs, so that the modeling process is high in flexibility.

### DESCRIPTION OF THE DRAWINGS

In order to more clearly illustrate the technical solutions in the embodiments of the present invention, the accompanying drawings that need to be used in the description of the embodiments will be briefly introduced below, and it is obvious that the drawings in the following description are some embodiments of the present invention, and for those skilled in the art, other drawings can also be obtained according to these accompanying drawings without paying creative labor.
FIG. 1 is a schematic diagram of a modeling framework;
FIG. 2 is a flowchart of a data modeling method according to an embodiment of the present invention;
FIG. 3 is a schematic diagram of interface interaction of a modeling tool according to an embodiment of the present invention;
FIG. 4 is a schematic diagram of interface interaction of a process of scanning unassigned parameters according to an embodiment of the present invention;
FIG. 5 is a flowchart of a data modeling method according to an embodiment of the present invention;
FIG. 6 is a flowchart of a data modeling method of an electric power system according to an embodiment of the present invention;
FIG. 7 is a schematic structural diagram of a data modeling apparatus according to an embodiment of the present invention; and
FIG. 8 is a schematic structural diagram of an electronic device according to an embodiment of the present invention.

### DETAILED DESCRIPTION

In order to make the objectives, technical solutions, and advantages of embodiments of the present invention clearer, the technical solutions in the embodiments of the present invention will be described clearly and completely with reference to the accompanying drawings in the embodiments of the present invention. It is apparent that the described embodiments are merely some of rather than all the embodiments of the present invention. Based on the embodiments in the present invention, all other embodiments obtained by a person skilled in the art without making creative labor belong to the scope of protection of the present invention.

Some embodiments of the present invention are described in detail below in conjunction with the accompanying drawings. Under the condition that there is no conflict between the embodiments, the following embodiments and the features in the embodiments may be combined with each other. In addition, the sequence of steps in the following method embodiments is only an example and is not strictly limited.

A data modeling method provided by an embodiment of the present invention may be executed by an electronic device; the electronic device may be a server or a user terminal; and the server may be a physical server or a virtual server (virtual machine) of a cloud.

First, some concepts involved in the embodiments of the present invention are described:
Adaptive Modeling Language (AML) is an object-oriented full-automatic engineering design framework development tool for a complex system. A complex optimization model may be converted into an abstract algebraic expression form to be inputted in a script program, and each optimization solver may be connected. Common modeling language tools may include AMPL (A Mathematical Programming Language), GAMS (The General engineering Modeling System), FICO Xpress, AIMMS and the like. Common solvers include MindOpt, Gurobi, CPLEX and the like.

Model file: it is called a model file by adopting a certain modeling language to compile a script program of a certain mathematical model defined by a user. The mathematical model involved in the embodiment of the present invention may be modeled for some linear and nonlinear mathematical programming problems; and correspondingly, code in the model file is used for describing the mathematical models, such as an objective function, an equation or inequation constraint, a decision variable and various parameters.

Data file: it includes data required by modeling and generates store parameter values of various parameters defined in the model.

Model instance: it is a specific model modeled by combining data values loaded from a data source such as the data file based on the model definition described in the model file. In summary, different data sources are different, and different model instances may be established for the same defined mathematical model. In summary, different data sources are different, and different model instances may be established for the same defined mathematical model.

Integrated Development Environment (IDE for short): it is an application program used for providing a program development environment and generally includes a code editor, a compiler, a debugger, a graphical user interface and other tools. It is a software development service set integrating a code writing function, an analysis function, a compiling function, a debugging function and the like.

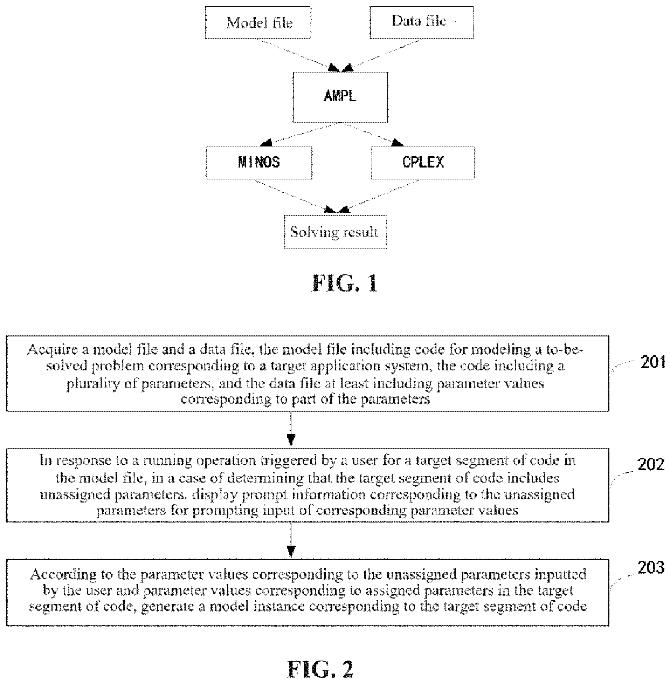

Taking the modeling language tool AMPL as an example, a universal modeling framework in FIG. 1 is adopted. As shown in FIG. 1, the AMPL reads the model file and the data file to generate a model instance, and then calls the solver capable of solving various mathematical programming problems (two solvers including MINOS and CPLEX are shown in FIG. 1) for solving to obtain a solution of a decision variable in the model instance.

FIG. 2 is a flowchart of a data modeling method according to an embodiment of the present invention; as shown in FIG. 2, the method includes the following steps:
201, Acquire a model file and a data file, the model file including code for modeling a to-be-solved problem corresponding to a target application system, the code including a plurality of parameters, and the data file at least including parameter values corresponding to part of the parameters.
202, In response to a running operation triggered by a user for a target segment of code in the model file, in a case of determining that the target segment of code include unassigned parameters, display prompt information corresponding to the unassigned parameters for prompting input of corresponding parameter values.
203, According to the parameter values corresponding to the unassigned parameters inputted by the user and parameter values corresponding to assigned parameters in the target segment of code, generate a model instance corresponding to the target segment of code.

The target application system may be any application system with an optimization problem solving requirement, such as an electric power system, and the problem to be solved may be an optimization problem. The user may define a corresponding mathematical model based on the problem to be solved in the target application system. From the composition angle, generally, the mathematical model is composed of an objective function and a plurality of constraint conditions, and the constraint conditions are expressed in the form of an equation or an inequation. A plurality of decision variables and a plurality of parameters are defined in the objective function and the constraint condition, the decision variables are unknown variables to be solved, and the parameters generally include coefficients corresponding to the decision variables and some constant terms.

After the user defines the mathematical model, the program code script may be compiled by the modeling language provided by certain modeling tool software to form the model file. Mathematical symbols, operators and the like will be provided in the modeling language for the user to use, and the user needs to follow the grammar required by the modeling language when compiling the model file so that the model file can be smoothly executed.

Besides compiling the model file, a data file needs to be generated. As described above, the mathematical model defined by the user includes a plurality of parameters, parameter values corresponding to some parameters may be directly given in the model file compiled by the user, parameter values corresponding to some parameters may be loaded from the data file, and these parameter values often reflect the actual state information of the target application system, so that the data file needs to be generated by collecting the related actual state data of the target application system.

It is to be noted that in order to provide greater flexibility for the modeling process, different from a traditional modeling process in which the user must give parameter values corresponding to all parameters when compiling the model file, the user, in this embodiment of the present invention, does not need to assign the parameter values of some parameters. Therefore, in this embodiment of the present invention, the parameters in the model file may be divided into two types: assigned parameters and unassigned parameters.

It is to be noted that the assigned parameters in this embodiment of the present invention are not limited to parameters whose parameter values are directly given by the user, but also include parameters for which corresponding parameter value reading paths are given in the data file. The unassigned parameters refer to parameters whose parameter values are default or whose default state is represented by a set character.

For example, for a parameter x, a situation of directly giving the parameter value is as follows: x=10, a situation that the reading path is given may be x={read"users/mdoAML/example/zpl/matching_set1.zpl" }, and the content in curly braces represents the reading path for reading the parameter value of the parameter x in the data file. A situation of an unassigned parameter may be as follows: x=&, & represents a preset placeholder, that is, when the setting position of the parameter value of a certain parameter is occupied by a preset character, the parameter may be considered as an unassigned parameter, and the preset character is a predefined character representing the unassigned state of the parameter. Definitely, optionally, the parameter value of the parameter may also be set to be in a default state, that is, the parameter value setting position is blank, so that the parameter is represented as an unassigned parameter.

Actually, as described above, the model file includes various variables to be solved in addition to parameters, and the variables are also in a state without corresponding values. Because different keywords are provided for definition of variables and parameters in the modeling language, which variables are parameters may be distinguished based on the keywords, for example, the keyword var is in front of the variables, and the keyword param is in front of the parameters.

In practical applications, the user may independently decide which parameters are used as unassigned parameters, and which parameters give corresponding parameter values or parameter value reading paths. However, the final purpose of supporting the user to set the unassigned parameters is to facilitate debugging of a model by the user, so more flexibility and convenience are provided for establishing a proper mathematical model; therefore, if the user sets most or even all parameters as unassigned parameters, or sets some parameters which are not necessarily set as unassigned parameters, unnecessary setting is generated; and according to an execution process of the target segment of code in the model file selected by the user under the "advanced running mode" introduced in the following text, when there are unassigned parameters in the code execution process, the user needs to input the assignment of the unassigned parameters in real time based on the current requirement, and thus the purpose that different users or the same user may flexibly set the parameter values of the unassigned parameters as required when debugging a section of code at different moments is achieved. Therefore, based on pre-analysis or expert suggestions, the user may be prompted to consider which types of parameters are set as unassigned parameters when modeling is carried out on a certain problem to be solved in the target application system. That is, these unassigned parameters are often parameters with special meanings, such as dates of data files, coefficients of certain variables in the model and other parts to be debugged and analyzed by users.

The date of the data file refers to that: in the model debugging process, corresponding model instances may be established based on data files collected in different dates; whether the model needs to be modified or not is determined based on the generated solving result of each model instance, and at the moment, the parameter, namely the date of the data file, may be set as an unassigned parameter, so that the user can input the data files corresponding to different dates according to needs during debugging.

For the coefficient of a certain variable, in the model debugging process, the user may continuously update the value of the coefficient, so that the effect of the solution of different model instances finally formed when different values are taken can be observed.

The development of the model file may be completed by a certain user independently or cooperatively by a plurality of users. After the model file is preliminarily developed, model debugging is needed. The debugging purpose is to check whether the designed mathematical model is reasonable or not, whether the compiled model file has errors or not and the like. In a traditional modeling tool, only the user is supported to debug the whole model file, namely, the whole model file needs to be executed in each debugging process. However, in the solution provided by this embodiment of the present invention, the user is supported to select part of code in the model file to execute, for example, the involved mathematical model includes a plurality of constraint conditions, the user wants to check whether a solution conforming to an expected variable can be obtained or not after removing part of the constraint conditions, and at the moment, the user may select the remaining code of the code corresponding to the part of constraint conditions in the model file to operate. The code selected by the user to be executed is called the target segment of code.

In order to be compatible with a running mode provided in a traditional modeling tool, in this embodiment of the present invention, the modeling tool supports the traditional running mode (which is distinguished as a conventional running mode), and a new running mode is also provided and is called an advanced running mode.

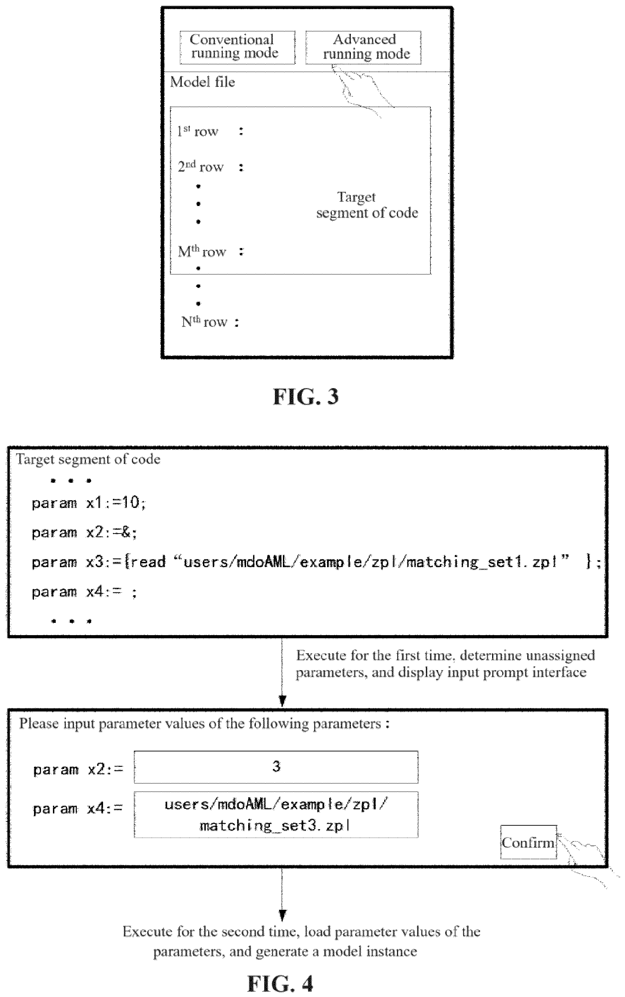

As shown in FIG. 3, in practical applications, the user may firstly open the model file in an IDE of the modeling tool; and in this interface, two running mode buttons shown in the figure may be provided: a conventional running mode and an advanced running mode. It is assumed that the model file includes a plurality of rows of code with the row numbers of 1-N shown in the figure, when the user selects 1-M rows of code as the target section code and clicks the advanced running mode, the running of the target section code in the advanced running mode is executed, N>M>1.

The conventional running mode refers to a mode of running all code in the whole model file, and in this mode, all parameters in the model file are required to be assigned parameters. Conversely, in the advanced running mode, all or part of code of the model file may be selected to run, and all or part of parameters in the model file are operated to be unassigned parameters.

In summary, when the target segment of code is run in the advanced running mode, two running processes need to be executed: in the first running process, the main purpose is to analyze whether the target segment of code include the unassigned parameters or not so as to prompt the user to assign the unassigned parameters after the first execution is finished; and the second execution process is a process of truly running the target segment of code to establish the model instance corresponding to the target segment of code based on the parameter values of the parameters contained in the target segment of code.

As described above, the parameters included in the target segment of code may be identified based on the setting keywords adopted during parameter definition; and furthermore, the unassigned parameters are determined according to whether the parameter values or parameter value reading paths are directly given at the setting positions of the parameter values or whether set placeholder characters representing that no parameter value is assigned are filled in or not or whether the parameter value positions are in a default state or not. If it is determined that the target segment of code includes unassigned parameters, prompt information may be displayed to prompt the user to input the parameter values corresponding to the unassigned parameters.

As described above, in step 202, based on the running operation (corresponding to the running operation of the advanced running mode) triggered by the user for the target segment of code in the model file, whether the target segment of code includes unassigned parameters or not is determined in the process of executing the target segment of code for the first time. In an optional embodiment, the process of displaying prompt information corresponding to the unassigned parameters may specifically include:
in the process of executing the target segment of code for the first time, determining whether each row of code includes unassigned parameters row by row;
in a case of determining that unassigned parameters are included, marking the unassigned parameters with a set character;
in a case that the target segment of code is completely executed, acquiring all unassigned parameters in the target segment of code according to the mark; and
displaying prompt information corresponding to all the unassigned parameters.

The set character is a placeholder character which is referred to in the above and represents that no parameter value is assigned. In practice, the user may mark the placeholders at parameter value setting positions of some unassigned parameters in the model file; however, the parameter value setting positions corresponding to some unassigned parameters are in the default state (empty); and in order to uniformly mark all unassigned parameters in the target segment of code in the first execution process, the identified unassigned parameters are uniformly marked with the set character, and the set character is marked at the parameter value setting position.

Besides, in the abovementioned embodiment, the displaying the prompt information corresponding to the unassigned parameters refers to uniformly prompting input of the parameter values of all the scanned unassigned parameters after completely traversing the target segment of code.

For ease of understanding, an example is taken in combination with FIG. 4. In FIG. 4, it is assumed that the selected target segment of code in the template file includes the following four rows of code:
param x1:=10;
param x2:=&;
param x3:={read"users/mdoAML/example/zpl/matching_set1.zpl" };
param x4:= ;
x1, x2, x3 and x4 are determined to be parameters based on a keyword param, the parameters x1 and x3 are determined to be assigned parameters, and the parameters x2 and x4 are determined to be unassigned parameters according to the content written in the parameter value setting positions; and & represents the set character. It is assumed that a row of code corresponding to x4 is the last row of target segment of code, in the process of traversing each row of code, for example, when x2 is found to be an unassigned parameter, that x2 is recorded as an unassigned parameter (for example, x2 is marked with the set character); and after traversing the last row of code, which parameters in the target segment of code are unassigned may be obtained based on the record result; then as shown in FIG. 4, an input prompt interface may be popped up in the interface; and an input prompt box corresponding to each unassigned parameter may be sequentially displayed in the input prompt interface. In order to facilitate the user to understand the meaning of each parameter, the description information of the corresponding parameter, such as the parameter name and the parameter meaning, is displayed in association with the input prompt box corresponding to each unassigned parameter.

The user inputs the parameter values corresponding to the unassigned parameters based on related prompt information, as shown in FIG. 4, it is assumed that the parameter value inputted by the user for the parameter x2 is 3, the parameter value inputted for the parameter x4 is {read"users/mdoAML/example/zpl/matching_set3.zpl" }. Based on the input operation of the user, the parameter values corresponding to the unassigned parameters inputted by the user and the unassigned parameters are correspondingly stored in a target storage space, such as a cache.

Two points need to be noted: 1, the parameter values inputted by the user are not directly assigned to the unassigned parameter in the model file, that is, the parameter value setting positions of the unassigned parameters in the model file is still in the default state or a state of filling in a placeholder character, and the assignment operation does not change the model file. 2, the purpose of executing the target segment of code for the first time is to find whether there are unassigned parameters in the target segment of code or not, so that the operation of loading the corresponding parameter values from the data file may not be executed for the assigned parameters giving the corresponding parameter value reading paths in the data file.

For the first point above, just because the state of the unassigned parameters in the model file is not changed, when the user selects a segment of code including the unassigned parameters again for debugging operation, different parameter values may be inputted again according to actual requirements, and it is limited by other parameter values inputted for the unassigned parameters before, so great flexibility is provided for repeated debugging of the code.

In an optional embodiment, the prompt information corresponding to the unassigned parameters is displayed on the interface, so that the user may display the assigned parameters and the parameter values thereof while inputting the parameter values based on the prompt information, and the user may check global parameters and parameter values corresponding to the global parameters.

In an optional embodiment, all parameters in the target segment of code may be identified based on that the definition parameter is the keyword o adopted, and then the prompt information corresponding to all the parameters is displayed, that is, which parameters are in the target segment of code is prompted to the user; and when the parameters are determined to be the assigned parameters, the parameter values corresponding to the assigned parameters may be displayed, and thus, the user may determine the unassigned parameters through an exclusive method.

After the user inputs the corresponding parameter values based on the prompt information corresponding to the unassigned parameters, in step 203, specifically, in the process of executing the target segment of code for the second time, the model instance corresponding to the target segment of code is generated according to the parameter values corresponding to the unassigned parameters inputted by the user and parameter values corresponding to assigned parameters in the target segment of code.

Specifically, as described above, the assigned parameters include parameters whose values are directly given and parameters for which corresponding parameter value reading paths in the data file are given; and then the process of generating a model instance corresponding to the target segment of code includes:
in response to the confirmation of completion of an assignment operation of the unassigned parameters triggered by the user, in a process of executing the target segment of code for the second time:
for the unassigned parameters, loading the parameter values corresponding to the unassigned parameters from the target storage space;
for the parameters for which corresponding parameter value reading paths in the data file are given, loading the corresponding parameter values from the data file according to the parameter value reading paths; and
according to the loaded parameter values corresponding to the unassigned parameters and parameter values corresponding to the assigned parameters, generating a model instance corresponding to the target segment of code.

As shown in FIG. 4, a "confirmation" button is arranged in the input prompt interface; when the user inputs the parameter values corresponding to the unassigned parameters and clicks the confirmation button, it is determined that the user confirms that the assignment operation of the unassigned parameters is completed, and the second execution process of the target segment of code is triggered. In the second execution process, all the parameters are completely traversed row by row, and parameter values corresponding to all the parameters are loaded. The parameter values which are inputted by the user and correspond to the unassigned parameters are stored in the target storage space, so that the parameter values of the unassigned parameters may be loaded from the target storage space. The assigned parameters of the parameter values are not directly given, and the parameter values are loaded from the data file.

Finally, based on the parameter values of the loaded parameters and function relations such as variables and parameters described in the model file, the creation of the model instance corresponding to the target segment of code is completed.

In order to understand the model instance, the following examples are illustrated: assuming that a designed mathematical model includes the following inequation constraint: ax+by<10, x and y represent variables, and a, b and 10 represent parameters; the model file includes a corresponding code describing the inequation, and the code will include definitions about the variables and the parameters. It is assumed that the two parameters a and b are set as unassigned parameters, the parameter values inputted by the user based on the prompt information are parameter value reading paths respectively; and assuming that the corresponding parameter value reading paths include three parameter values: ai, a₂ and a₃, and b₁, b₂ and bs. Three specific inequation instances will be generated based on the loading result of the parameter value: a1x+b1y<10, a2x+b2y<10, a3x+b3y<10. The meaning of the corresponding instance is explained only by taking one inequation constraint as an example, in fact, the target segment of code may include various functional relations such as equations and inequations defined in the mathematical model; each functional relation may generate one or more specific instances; and all the instances form a model instance corresponding to the target segment of code.

Then, a solver corresponding to the model instance may be called to solve variables of the model instance. The solving result of the model instance may be displayed in the interface, so that the user may check the solving result. If the solving result does not accord with the expectation, for example, the solving result does not accord with the actual operation condition of the target application system, or the running of the target application system is not suitable for being controlled according to the solving result, the user may update the previously designed mathematical model.

For example, if the previously designed mathematical model includes 15 constraint conditions and one objective function, and when the user selects 14 constraint conditions and code corresponding to the objective function as the target segment of code to carry out running in the advanced running mode and finds that the solving result of the corresponding model instance is better than the solving result corresponding to the model instance established based on all 15 constraint conditions, the user may update the mathematical model as only including the 14 constraint conditions.

Besides, in the process of executing the target segment of code for the second time, in order to prevent abnormal execution, grammar detection may be carried out on the target segment of code firstly to detect whether grammar errors exist in the target segment of code or not; and if the grammar errors exist, error reporting is carried out, so that the user corrects the grammar errors.

In conclusion, based on the advanced running mode of the model file according to this embodiment of the present invention, when the selected target segment of code to be executed in the model file is analyzed, and if unassigned parameters are met, the unassigned parameters are represented in a placeholder form, and after the whole selected code is analyzed for the first time, a dialog box will be popped up for a user to set the parameter values of the unassigned parameters, so that the modeling process is executed based on the parameter values inputted by the user. The advanced running mode provides greater flexibility for the user to repeatedly debug the mathematical model for multiple times.

Moreover, based on the advanced running mode, the security of the model file may be ensured when a plurality of persons use the same mathematical model. For example, the model file is developed by the user A, although other users except the user A are allowed to debug the model file, if only the user A has the permission to modify the model file, based on the plurality of unassigned parameters set by the user A in the model file and the advanced running mode, other users may select the target segment of code as required and assign the unassigned parameters in the target segment of code as required in the debugging process of the model, but the other users do not have the permission to modify the model file, so that the parameter value setting of each parameter (including the unassigned parameters) in the model file cannot be changed by the debugging processes of different users, and the security of the model file is ensured.

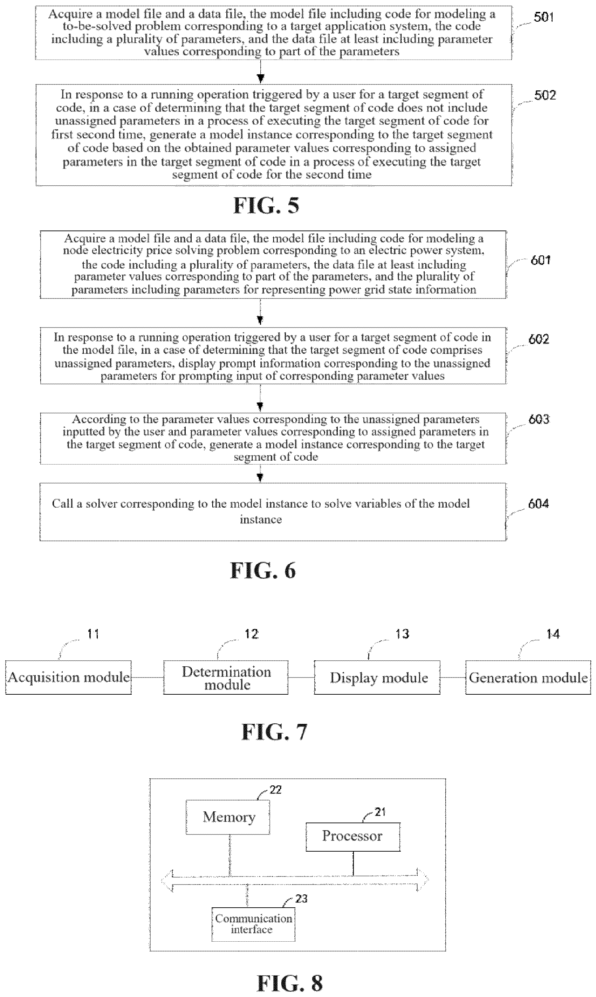

The above embodiment shows that there are unassigned parameters in the target segment of code selected by the user, and the debugging process without unassigned parameters in the target segment of code is described in combination with FIG. 5.

FIG. 5 is a process of a data modeling method according to an embodiment of the present invention, as shown in FIG. 5, the method includes the following steps:
501, Acquire a model file and a data file, the model file including code for modeling a to-be-solved problem corresponding to a target application system, the code including a plurality of parameters, and the data file at least including parameter values corresponding to part of the parameters.
502, In response to the running operation triggered by the user for the target segment of code, in a case of determining that the target segment of code does not include unassigned parameters in the process of executing the target segment of code for the first time, generate the model instance corresponding to the target segment of code based on the obtained parameter values corresponding to the assigned parameters in the target segment of code in a process of executing the target segment of code for the second time.

Therefore, when the user selects the target segment of code and triggers a specific advanced running mode, the target segment of code is analyzed row by row in the process of executing the target segment of code for the first time to determine whether the unassigned parameter is in the target segment of code or not; and if it is not found that the unassigned parameter is in the target segment of code after the target segment of code is traversed, the process of executing the target segment of code for the second time is automatically executed. At the moment, it is indicated that all the parameters contained in the target segment of code are assigned parameters. In the process of executing the target segment of code for the second time, the model instance corresponding to the target segment of code is generated based on the parameter values corresponding to the assigned parameters in the obtained target segment of code. Then a related solver is called to solve the model instance.

The data modeling method according to this embodiment of the present invention may be applied to any application system with corresponding mathematical model modeling requirements, such as an electric power system.

FIG. 6 is a flowchart of a data modeling method of an electric power system according to an embodiment of the present invention. As shown in FIG. 6, the method includes the following steps:
601, Acquire a model file and a data file, the model file including code for modeling a node electricity price solving problem corresponding to the electric power system, the code including a plurality of parameters, the data file at least including parameter values corresponding to part of the parameters, and the plurality of parameters including parameters for representing power grid state information.
602, In response to a running operation triggered by a user for a target segment of code in the model file, in a case of determining that the target segment of code include unassigned parameters, display prompt information corresponding to the unassigned parameters for prompting input of corresponding parameter values.
603, According to the parameter values corresponding to the unassigned parameters inputted by the user and parameter values corresponding to assigned parameters in the target segment of code, generate a model instance corresponding to the target segment of code.
604, Call a solver corresponding to the model instance to solve variables of the model instance.

In the electric power system, a main problem to be solved is the problem of determining node electricity price. The node electricity price refers to the marginal cost when the unit load demand is increased at a certain node under a condition that the operation characteristics and constraint conditions of various devices and resources are met, namely, the increased cost required for consuming "more than one kilowatt hour" at a certain time and a certain place is represented. Generally, "device and resources" influencing the node electricity price mainly refer to a generator set and a power transmission line, and the "running characteristics and constraint conditions" include power load balance, maximum and minimum output and climbing of the generator set, transmission capacity of the power transmission line and a power transmission section in normal and fault states and the like.

When calculating the node electricity price, a node electricity price clearing model needs to be used, which is a mathematical model used for calculating the node electricity price, and may be a model which takes variables such as active power of a unit node as decision variables, has network security constraints and takes minimization of the total cost as a target. The node electricity price clearing model is actually a linear programming model.

Linear programming model: it is a mathematical model; the decision variables of the mathematical model are all continuous real variables; and an objective function and constraint conditions are both linear. After a standard algorithm or a solving program is used for solving, the decision variables will be divided into a basic variable and a non-basic variable, and a shadow price will be assigned to each constraint condition.

The shadow price of each constraint corresponding to each node is added to finally form the node electricity price of the nodes.

As described above, in order to calculate the node electricity price, a mathematical model is to be defined, namely the node electricity price clearing model, and then, a corresponding model file is developed by the user for the definition of the mathematical model; the model file includes a plurality of decision variables and a plurality of parameters; and the relationship and values between the parameters and the variables are described according to the objective function and various constraints defined in the mathematical model.

In addition, because the node electricity price is scheduled in real time, real-time state information of the power grid needs to be acquired for each scheduling time to form the data file, and the power grid state information corresponds to a plurality of parameters defined in the model file. The parameters representing the power grid state information include, for example, some types of data such as: related data of each unit node in the power grid system, load data of the load node, and topological structure data of the power grid system. The related data of each unit node may include: the maximum climbing rate, the maximum and minimum power generation capacity, the startup cost, the operation cost and the like of each unit node. The topological structure data of the power grid system includes the active power flow limit of each power transmission line, the connection relationship between each node and the line and the like.

As described above, when the user defines parameters in the model file, parameter values of some parameters may be assigned or not assigned. For example, parameters corresponding to dynamically changing information in some power grid state information may be set as unassigned parameters, and parameters corresponding to some stable and unchanged information may be set as assigned parameters.

When the user performs model debugging, the whole model file or one segment of code in the model file may be selected as the debugging object (called the target segment of code), and then the advanced running mode is selected to trigger operation of the target segment of code. Then, as described above, firstly, whether the target segment of code includes unassigned parameters or not is determined, and if yes, the prompt information corresponding to the unassigned parameters will be displayed. Specifically, in the process of executing the target segment of code for the first time, whether each row of code include the unassigned parameters or not is determined row by row, if it is determined that the unassigned parameters are included, the set character is marked for the unassigned parameters; and if execution of the target segment of code is completed, all unassigned parameters in the target segment of code are acquired according to the mark, and the prompt information corresponding to all the unassigned parameters is displayed. The user performs assignment operation on the unassigned parameters based on the prompt information, for example, the parameter values corresponding to certain unassigned parameters are given, or the parameter value reading paths corresponding to the unassigned parameters are given, so that the parameter values are loaded from the corresponding data file according to the reading paths subsequently.

Then, in response to the confirmation of completion of the assignment operation of the unassigned parameters triggered by the user, the unassigned parameters and the parameter values corresponding to the unassigned parameters are stored in a target storage space; and in the process of executing the target segment of code for the second time, it includes: for the unassigned parameters, loading the parameter values corresponding to the unassigned parameters from the target storage space; for the parameters for which corresponding parameter value reading paths in the data file are given, loading the corresponding parameter values from the data file according to the parameter value reading paths; and according to the loaded parameter values corresponding to the unassigned parameters and parameter values corresponding to the assigned parameters, generating a model instance corresponding to the target segment of code. Then, the corresponding solver is called to complete the solution of the model instance.

The content which is not detailed in this embodiment may refer to related description in other embodiments and is not detailed here.

A data modeling apparatus according to one or more embodiments of the present invention is described in detail below. Those skilled in the art can understand that these devices can be constructed using commercially available hardware components and configured through the steps taught in this solution.

FIG. 7 is a schematic structural diagram of a data modeling apparatus according to an embodiment of the present invention, as shown in FIG. 7, the apparatus includes: an acquisition module 11, a determination module 12, a display module 13 and a generation module 14.

The acquisition module 11 is configured to acquire a model file and a data file, the model file including code for modeling a to-be-solved problem corresponding to a target application system, the code including a plurality of parameters, and the data file at least including parameter values corresponding to part of the parameters.

The determination module 12 is configured to, in response to a running operation triggered by a user for a target segment of code in the model file, determine whether the target segment of code includes unassigned parameters.

The display module 13 is configured to, in a case of determining that the target segment of code includes unassigned parameters by the determination module 12, display prompt information corresponding to the unassigned parameters for prompting input of corresponding parameter values.

The generation module 14 is configured to, according to the parameter values corresponding to the unassigned parameters inputted by the user and parameter values corresponding to assigned parameters in the target segment of code, generate a model instance corresponding to the target segment of code.

Optionally, the apparatus further includes: a solving module which is configured to call a solver corresponding to the model instance to solve variables of the model instance.

Optionally, the determination module 12 is specifically configured to: in the process of executing the target segment of code for the first time, determine whether each row of code includes unassigned parameters row by row; in a case of determining that unassigned parameters are included, mark a set character for the unassigned parameters; and display prompt information corresponding to all the unassigned parameters.

Optionally, the assigned parameters include parameters whose values are directly given and parameters for which corresponding parameter value reading paths in the data file are given; and the determination module 12 is specifically configured to: in the process of executing the target segment of code for the first time, not execute an operation of loading the corresponding parameter values according to the parameter value reading paths.

Optionally, the apparatus further includes: a storage module which is configured to store the unassigned parameters and the parameter values corresponding to the unassigned parameters in a target storage space.

Optionally, the assigned parameters include parameters whose values are directly given and parameters for which corresponding parameter value reading paths in the data file are given; and the generation module 14 is specifically configured to: in response to the confirmation of completion of the assignment operation of the unassigned parameters triggered by the user, in a process of executing the target segment of code for the second time: for the unassigned parameters, load the parameter values corresponding to the unassigned parameters from the target storage space; for the parameters for which corresponding parameter value reading paths in the data file are given, load the corresponding parameter values from the data file according to the parameter value reading paths; and according to the loaded parameter values corresponding to the unassigned parameters and parameter values corresponding to the assigned parameters, generate a model instance corresponding to the target segment of code.

Optionally, the generation module 14 is further configured to: perform grammar detection on the target segment of code before generating the model instance corresponding to the target segment of code.

Optionally, the determination module 12 is further configured to: in response to the running operation triggered by the user for the target segment of code, in a case of determining that the target segment of code does not include unassigned parameters in the process of executing the target segment of code for the first time, trigger the generation module 14 to generate the model instance corresponding to the target segment of code based on the obtained parameter values corresponding to the assigned parameters in the target segment of code in a process of executing the target segment of code for the second time.

The apparatus shown in FIG. 7 may execute the steps provided in the abovementioned embodiment, and the detailed execution process and technical effect take part in the description in the abovementioned embodiment and are not repeated here.

In a possible design, the structure of the data modeling apparatus shown in FIG. 7 may be realized as an electronic device. As shown in FIG. 8, the electronic device may include: a processor 21, a memory 22 and a communication interface 23. Executable code is stored on the memory 22; and when the processor 21 executes the executable code, the processor 21 may at least realize the data modeling method provided in the abovementioned embodiment.

In addition, an embodiment of the present invention provides a non-temporary machine-readable storage medium; executable code is stored on the non-temporary machine-readable storage medium; and when the processor of the electronic device executes the executable code, the processor may at least realize the data modeling method provided in the abovementioned embodiment.

The apparatus embodiments described above are only schematic, and the network elements described therein as a description of the detached parts may or may not be physically separated. Some or all of the modules can be selected according to actual needs to realize the purpose of this embodiment. A person skilled in the art can understand and implement it without creative labor.

From the description of the above implementations, those skilled in the art may clearly understand that the various implementations may be implemented by means of software plus a necessary general hardware platform, and definitely may also be implemented by a combination of hardware and software. Based on this understanding, the abovementioned technical solution may be embodied in the form of a computer product in essence or a part that contributes to the prior art, and the present invention may take the form of a computer program product implemented on one or more computer-available storage media (including but not limited to disk memory, CD-ROM, optical memory, etc.) containing computer-available program code.

Finally, it is be noted that the above embodiments are only used for illustrating the technical solutions of the present invention, not for limiting them, and although the present invention is described in detail with reference to the foregoing embodiments, a person skilled in the art should understand that it can still modify the technical solutions recorded in the abovementioned embodiments, or replace some of the technical features therein, and these modifications or substitutions do not make the essence of the corresponding technical solutions detached from the spirit and scope of the technical solutions of the embodiments of the present invention.

## Claims

1. A data modeling method, comprising:
acquiring a model file and a data file, the model file comprising code for modeling a to-be-solved problem corresponding to a target application system, the code comprising a plurality of parameters, and the data file at least comprising parameter values corresponding to part of the parameters;
in response to a running operation triggered by a user for a target segment of code in the model file, in a case of determining that the target segment of code comprises unassigned parameters, displaying prompt information corresponding to the unassigned parameters for prompting input of corresponding parameter values; and
according to the parameter values corresponding to the unassigned parameters inputted by the user and parameter values corresponding to assigned parameters in the target segment of code, generating a model instance corresponding to the target segment of code.

2. The method according to claim 1, further comprising:
calling a solver corresponding to the model instance to solve variables of the model instance.

3. The method according to claim 1, wherein said in a case of determining that the target segment of code comprises unassigned parameters, displaying prompt information corresponding to the unassigned parameters comprises:
in a process of executing the target segment of code for the first time, determining whether each row of code comprises unassigned parameters row by row;
in a case of determining that unassigned parameters are comprised, marking the unassigned parameters with a set character;
in a case that the target segment of code is completely executed, acquiring all unassigned parameters comprised in the target segment of code according to the mark; and
displaying prompt information corresponding to all the unassigned parameters.

4. The method according to claim 3, wherein the assigned parameters comprise parameters whose values are directly given and parameters for which corresponding parameter value reading paths in the data file are given; and
in the process of executing the target segment of code for the first time, an operation of loading the corresponding parameter values according to the parameter value reading paths is not executed.

5. The method according to claim 3, further comprising:
displaying prompt information corresponding to the assigned parameters.

6. The method according to any one of claims 1 to 4, further comprising:
storing the unassigned parameters and the parameter values corresponding to the unassigned parameters in a target storage space.

7. The method according to claim 6, wherein the assigned parameters comprise parameters whose values are directly given and parameters for which corresponding parameter value reading paths in the data file are given; and
said according to the parameter values corresponding to the unassigned parameters inputted by the user and parameter values corresponding to assigned parameters in the target segment of code, generating a model instance corresponding to the target segment of code comprises:
in response to the confirmation of completion of the assignment operation of the unassigned parameters triggered by the user, in a process of executing the target segment of code for the second time:
for the unassigned parameters, loading the parameter values corresponding to the unassigned parameters from the target storage space;
for the parameters for which corresponding parameter value reading paths in the data file are given, loading the corresponding parameter values from the data file according to the parameter value reading paths; and
according to the loaded parameter values corresponding to the unassigned parameters and parameter values corresponding to the assigned parameters, generating a model instance corresponding to the target segment of code.

8. The method according to claim 1, further comprising:
in response to the running operation triggered by the user for the target segment of code, in a case of determining that the target segment of code does not comprise unassigned parameters in a process of executing the target segment of code for the first time, generating the model instance corresponding to the target segment of code based on the obtained parameter values corresponding to the assigned parameters in the target segment of code in a process of executing the target segment of code for the second time.

9. A data modeling apparatus, comprising:
an acquisition module which is configured to acquire a model file and a data file, the model file comprising code for modeling a to-be-solved problem corresponding to a target application system, the code comprising a plurality of parameters, and the data file at least comprising parameter values corresponding to part of the parameters;
a determination module which is configured to, in response to a running operation triggered by a user for a target segment of code in the model file, determine whether the target segment of code comprises unassigned parameters;
a display module which is configured to, in a case of determining that the target segment of code comprises unassigned parameters by the determination module, display prompt information corresponding to the unassigned parameters for prompting input of corresponding parameter values; and
a generation module which is configured to, according to the parameter values corresponding to the unassigned parameters inputted by the user and parameter values corresponding to assigned parameters in the target segment of code, generate a model instance corresponding to the target segment of code.

10. An electronic device, comprising a memory, a processor, and a communication interface, wherein executable code is stored on the memory; and when the executable code is executed by the processor, the processor executes the data modeling method according to any one of claims 1 to 8.

11. A non-temporary machine-readable storage medium, storing executable code; wherein when the executable code is executed by a processor of an electronic device, the processor executes the data modeling method according to any one of claims 1 to 8.

12. A data modeling method of an electric power system, comprising:
acquiring a model file and a data file, the model file comprising code for modeling a node electricity price solving problem corresponding to the electric power system, the code comprising a plurality of parameters, the data file at least comprising parameter values corresponding to part of the parameters, and the plurality of parameters comprising parameters for representing power grid state information;
in response to a running operation triggered by a user for a target segment of code in the model file, in a case of determining that the target segment of code comprises unassigned parameters, displaying prompt information corresponding to the unassigned parameters for prompting input of corresponding parameter values; and
according to the parameter values corresponding to the unassigned parameters inputted by the user and parameter values corresponding to assigned parameters in the target segment of code, generating a model instance corresponding to the target segment of code; and
calling a solver corresponding to the model instance to solve variables of the model instance.

13. The method according to claim 12, wherein said in a case of determining that the target segment of code comprises unassigned parameters, displaying prompt information corresponding to the unassigned parameters comprises:
in a process of executing the target segment of code for the first time, determining whether each row of code comprises unassigned parameters row by row;
in a case of determining that unassigned parameters are comprised, marking the unassigned parameters with a set character;
in a case that the target segment of code is completely executed, acquiring all unassigned parameters comprised in the target segment of code according to the mark; and
displaying prompt information corresponding to all the unassigned parameters.
